(19) Europäisches Patentamt
European Patent Office
Office européen des brevets

(11) **EP 4 361 649 B1**

(12) **EUROPÄISCHE PATENTSCHRIFT**

(45) Veröffentlichungstag und Bekanntmachung des Hinweises auf die Patenterteilung:
**16.04.2025  Patentblatt 2025/16**

(21) Anmeldenummer: **23202907.4**

(22) Anmeldetag: **11.10.2023**

(51) Internationale Patentklassifikation (IPC):
**G01R 27/02** *(2006.01)*    **B60L 3/00** *(2019.01)*
**B60R 16/03** *(2006.01)*

(52) Gemeinsame Patentklassifikation (CPC):
**G01R 27/025; B60L 3/0069**

(54) **VERFAHREN ZUR BESCHLEUNIGUNG DER ISOLATIONSWIDERSTANDSMESSUNG IN EINEM UNGEERDETEN STROMVERSORGUNGSSYSTEM**

METHOD FOR ACCELERATING INSULATION RESISTANCE MEASUREMENT IN AN UNGROUNDED POWER SYSTEM

PROCÉDÉ D'ACCÉLÉRATION DE MESURE DE RÉSISTANCE D'ISOLATION DANS UN SYSTÈME D'ALIMENTATION ÉLECTRIQUE NON MIS À LA TERRE

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität:  **25.10.2022  DE 102022128126**

(43) Veröffentlichungstag der Anmeldung:
**01.05.2024  Patentblatt 2024/18**

(73) Patentinhaber: **Bender GmbH & Co. KG**
**35305 Grünberg (DE)**

(72) Erfinder:
• **HUANG, Zhongkui**
**35415 Pohlheim (DE)**
• **GRÜN, Matthias**
**35315 Homberg (DE)**

(74) Vertreter: **advotec.**
**Patent- und Rechtsanwaltspartnerschaft**
**Tappe mbB**
**Georg-Schlosser-Straße 6**
**35390 Gießen (DE)**

(56) Entgegenhaltungen:
**DE-A1- 102021 203 919    DE-B3- 102021 101 693**

**Beschreibung**

Die Erfindung betrifft Verfahren zur Beschleunigung der Isolationswiderstandsmessung für die Anwendung in einem Verfahren zur Bestimmung eines Isolationswiderstands nach einem Impuls-Messverfahren in einem ungeerdeten Stromversorgungssystem (IT-System) gemäß des jeweiligen Oberbegriffs in den Ansprüchen 1 und 8.

Die Anwendung in beiden Varianten des erfindungsgemäßen Verfahrens setzt ein bestehendes, übergeordnetes Verfahren zur Isolationsüberwachung voraus, bei welchem nach einem Impuls-Messverfahren eine aus zeitlich aufeinanderfolgenden Rechteck-Messimpulsen zusammengesetzte Messspannung zwischen mindestens einen aktiven Leiter des ungeerdeten Stromversorgungssystems und Erde mittels eines Messimpulsgenerators über einen Ankoppelzweig mit einem Ankoppelwiderstand und einem Messwiderstand angelegt wird und ein zeitkontinuierlicher Kurvenverlauf einer über dem Messwiderstand gemessenen Spannung erfasst wird.

Neben dem Einsatz der erfindungsgemäßen Verfahren für stationäre ungeerdete Stromversorgungssysteme, beispielsweise in Industrieanlagen oder Krankenhäusern, verdient insbesondere die Elektromobilität im Hinblick auf die elektrische Sicherheit besondere Aufmerksamkeit.

Im Automobilbereich gewinnt die Überwachung des Isolationswiderstands des ungeerdeten Stromversorgungssystems zunehmend an Bedeutung, da das Stromversorgungssystem im Elektrofahrzeug ein isoliert aufgebautes Stromversorgungssystem darstellt und der Isolationswiderstand ein wichtiger Indikator für den Qualitätszustand der bordeigenen elektrischen Installation ist.

Zur kontinuierlichen Überwachung des Isolationswiderstands werden daher Isolationsüberwachungsgeräte eingesetzt. In der Testnorm LV 123 sind Prüfbedingungen für den Test von Hochvolt-Komponenten für Elektrofahrzeuge festgelegt. Für die Isolationswiderstandsmessung werden dabei zwei Messmodi unterschieden: Zum einen die Norm LV123-639 für den Normalbetrieb und zum anderen die Norm LV123-1735 für den Schnellstartmodus.

Der Norm LV123-639 ist zu entnehmen, dass die Zeitdauer bis zur Ausgabe eines gültigen Isolationswiderstandswertes kleiner als 30s betragen muss, sofern die Anforderungsdokumentation des Erstausrüsters keine anderen Angaben enthält.

Ist eine schnelle Isolationsüberwachung gefordert, so wird gemäß der Norm LV123-1735 gefordert, dass die Zeitdauer bis zur Ausgabe eines gültigen Isolationswiderstandswertes kleiner als 5s betragen muss und eine Messtoleranz von 0% bis -50% im Bereich von 100 Ohm/V bis 500 Ohm/V einzuhalten ist.

Darüber hinaus legt die weitere Norm LV123-1734 fest, dass die Zeitdauer bis zur Ausgabe eines gültigen Isolationswiderstandswertes in Abhängigkeit der Werte von Ableitkapazitäten und Y-Kondensatoren bis zu $2\mu F$ und in Abhängigkeit des Hochvolt-Potenzials von dem Erstausrüster anzugeben ist.

Auch in Verbindung mit der Norm DIN EN 61557-8, welche die Anforderungen an Isolationsüberwachungsgeräte für IT-Systeme beschreibt, ist ein Schnellstart der Isolationswiderstandsmessung ebenfalls von Bedeutung. So erscheint es sinnvoll, wenn beispielsweise in Verbindung mit der Isolationsüberwachung in einem Elektrofahrzeug der Fahrer nach dem Start des elektrischen Systems eine Nachricht erhielte, dass der Isolationszustand des Bordnetzes "sicher" ist oder im Sinne einer Warn- oder Fehlermeldung als "nicht sicher" bewertet wird.

Die Schnellstart-Anforderung der Bereitstellung eines Isolationswiderstandswerts innerhalb von 5s kann nicht immer erfüllt werden, da die Ableitkapazitäten des IT-Netzes (Bordnetz des Elektrofahrzeugs) und die Y-Kondensatoren eines Verbrauchers oftmals in Verbindung mit einer Isolationsüberwachung nach dem Impuls-Messverfahren noch eine Restspannung aufgrund der Umladung mit dem Messimpuls eines vorangegangenen Messzyklus aufweisen. Eine vorzeitige, also während des (Um-)Ladevorgangs ermittelte, Aussage über den Isolationszustand, insbesondere, ob die Schnellstart-Anforderung erfüllt wird, ist derzeit gemäß dem Stand der Technik nicht möglich, da sämtliche Verfahren auf Informationen beruhen, die erst nach Abschluss der (Um-)Ladevorgänge zur Verfügung stehen.

Aus dem Stand der Technik ist in der Patentschrift DE 10 2021 101 693 B3 in Verbindung mit einem Impuls-Messverfahren zur Isolationsüberwachung ein Verfahren zur Messimpuls-Fehlererkennung bekannt, bei dem eine fortlaufende Berechnung von Zeitkonstanten erfolgt und daraus eine Angabe über die Zuverlässigkeit der Isolationswiderstandsmessung abgeleitet wird. Eine Aussage, ob die Schnellstart-Anforderung erfüllt werden kann, wird nicht getroffen.

Der vorliegenden Erfindung liegt somit die Aufgabe zu Grunde, ein Verfahren vorzuschlagen, mit dem in Verbindung mit einem Impuls-Messverfahren zur Isolationsüberwachung möglichst frühzeitig eine Aussage über den Isolationszustand getroffen werden kann, insbesondere, ob die Anforderung der Bereitstellung eines Isolationswiderstandswerts innerhalb einer vorgegebenen Schnellstartzeit erfüllt werden kann.

Diese Aufgabe wird in Verbindung mit den Merkmalen in dem Oberbegriff des Anspruchs 1 gelöst durch Vorgeben eines Ziel-Ladezustands der in dem ungeerdeten Stromversorgungssystem vorhandenen Netzkapazitäten, Berechnen eines Ziel-Zeitpunktes, an dem die Netzkapazitäten den Ziel-Ladezustand erreicht haben werden, aus dem Ziel-Ladezustand (r) und dem effektiven tau-Wert,

Berechnen einer ersten Wartezeit ausgehend von dem aktuellen Zeitpunkt als Differenz zwischen dem Ziel-Zeitpunkt und dem aktuellen Zeitpunkt und Ausgeben eines Sicher-Starten-Signals, falls die erste Wartezeit kleiner als eine vorgegebene Schnellstartzeit ist, andernfalls Ausgeben eines Nicht-Sicher-Starten-Signals.

Grundlage der Überlegungen sind aus dem Stand der Technik bekannte Messverfahren zur Isolationsüberwachung, die eine getaktete Messspannung verwenden, bei der von dem Messimpulsgenerator der Isolations-überwachungseinrichtung (Isolationsüberwachungsgerät) nach dem Impuls-Messverfahren eine aus zeitlich aufeinanderfolgenden Rechteck-Messimpulsen zusammengesetzte Messspannung zwischen mindestens einen aktiven Leiter des Stromversorgungssystems und Erde (Chassis des Elektrofahrzeugs) eingespeist wird. Es stellt sich in diesem Messkreis ein über den Isolationswiderstand fließender Strom ein, der an einem Messwiderstand einen proportionalen Spannungsabfall bewirkt. Eine Messung dieser Spannung (gemessene Spannung) gibt damit Aufschluss über die Größe des Isolationswiderstands und damit über den Isolationszustand des (automobilen) ungeerdeten Stromversorgungssystems.

Da das ungeerdete Stromversorgungssystem gegenüber Erde unvermeidliche elektrische Kapazitäten (Netzableitkapazitäten) und Y-Kondensatoren der Verbraucher zur Störungsunterdrückung aufweist, werden die Genauigkeit und insbesondere die Schnelligkeit der Messung des Isolationswiderstands negativ beeinflusst.

Im Folgenden werden die Netzableitkapazitäten und Y-Kondensatoren unter dem Begriff Netzkapazitäten zusammengefasst und diese kapazitive Anordnung vereinfachend als Kondensator bezeichnet.

Aus der Betrachtung der kapazitätsaufladenden e-Funktion (natürliche Exponentialfunktion) und der daraus abgeleiteten, durch den Innenwiderstand des Isolationsüberwachungsgerätes, den Isolationswiderstand und die Netzkapazitäten (RC-Glied) beeinflussten, Zeitkonstanten können bei der Aufladung bzw. Entladung der Netzkapazitäten wichtige Erkenntnisse über den Isolationszustand, insbesondere bei dem Hochfahren eines mobilen Bordnetzes, gewonnen werden.

In einem ersten Verfahrensschritt wird aus dem (zeitkontinuierlichen) Kurvenverlauf der gemessenen Spannung mittels digitaler Signalverarbeitung eine Folge von zeitdiskreten Ausgangsspannungs-Messwerten gebildet, die für die weitere Berechnungen gespeichert werden.

In den darauffolgenden Berechnungen werden die mathematischen Gesetzmäßigkeiten, die für die Ableitungsregeln der e-Funktion gelten, auf den technischen Sachverhalt der kapazitätsaufladenden e-Funktion angewendet, durch die der Spannungsverlauf bei der Aufladung der Netzkapazitäten in dem ungeerdeten Stromversorgungssystem beschrieben wird.

Ausgangspunkt der Betrachtungen ist somit der Zusammenhang - hier vereinfachend mit zeitkontinuierlichen Größen eines Spannungsverlaufs V (t) (Kondensatorspannung) für ein allgemeines RC-Glied ausgedrückt

$$\frac{V'(t)}{V''(t)} = -RC = -tau$$

mit

$$V(t) = V_0 * \left(1 - e^{-\frac{t}{RC}}\right)$$

bei der Ladung und

$$V(t) = V_0 * e^{-\frac{t}{RC}}$$

bei der Entladung, wobei V'(t), V"(t) erste und zweite zeitkontinuierliche Ableitungen (Differentialquotienten) von V(t) sind.

Für die digitale Signalverarbeitung der zeitdiskreten Messwerte gehen die zeitkontinuierlichen Ableitungen in die Differenzenquotienten erster und zweiter Ordnung über. Die zeitdiskreten Ausgangsspannungs-Messwerte sowie deren Differenzenquotienten erster und zweiter Ordnung dienen damit als Ausgangsbasis für die anschließende Berechnung von Zeitkonstanten.

Die Zeitkonstanten ergeben sich als negativer Quotient aus einem Differenzenquotient erster Ordnung und einem Differenzenquotient zweiter Ordnung von zeitlich aufeinanderfolgenden zeitdiskreten Ausgangsspannungs-Messwerten in einem Berechnungszeitraum, der innerhalb einer Einschwingphase des Rechteck-Messimpulses liegt.

Der Berechnungszeitraum, in dem die Berechnung der Zeitkonstanten fortlaufend auf die zeitdiskreten Ausgangsspannungs-Messwerte angewendet wird, erstreckt sich innerhalb der Einschwingphase des Rechteck-Messimpulses von dem Zeitpunkt der Beendigung des Einschwingvorgangs des Tiefpassfilters bis zu Beginn der Sättigungsphase der zeitdiskreten Ausgangsspannungs-Messwerte.

Unter Anwendung einer einstufigen oder mehrstufigen Zeitkonstanten-Mittelwertbildung wird aus den so gebildeten Zeitkonstanten ein effektiver tau-Wert als für weitere Berechnungen abschließend verfügbare Zeitkonstante berechnet, die als grundlegende Größe in die Prüfung eingeht, ob die Schnellstart-Bedingung erfüllt werden kann.

In einer ersten Variante des erfindungsgemäßen Verfahrens dient als Eingangsparameter ein vorgegebener Ziel-Ladezustand für die in dem ungeerdeten Stromversorgungssystem vorhandenen Netzkapazitäten, der das Verhältnis der in diesem Ziel-Ladezustand erreichten Ziel-Ladespannung zu einem stationären Endwert (Voll-Ladespannung) der über den Netzkapazitäten anliegenden Spannung (Kondensatorspannung) bezeichnet. Es muss also eine (prozentuale) Zielvorgabe bekannt sein, die einen für die Isolationswiderstandsmessung gültigen, hinreichend stationären Ladezustand der Kondensatoren widerspiegelt und mittels eines Prozentsatzes, bezogen auf eine Voll-Ladespannung der Kondensatoren, vorgegeben wird. Beispielsweise sollen 99% der Voll-Ladespannung (Ziel-Ladezustand 0.99) erreicht werden, um dann prüfen zu können, ob dieser Ziel-Ladezustand innerhalb einer vorgegebenen Schnellstartzeit erreichbar ist.

Mit dem Ziel-Ladezustand und dem effektiven tau-Wert kann der Ziel-Zeitpunkt ermittelt und daraus eine erste Wartezeit ausgehend von dem aktuellen Zeitpunkt als Differenz zwischen dem Ziel-Zeitpunkt und dem aktuellen Zeitpunkt berechnet werden.

Abschließend erfolgt ein Ausgeben eines Sicher-Starten-Signals (ss), falls die erste Wartezeit (dTr) kleiner als eine vorgegebene Schnellstartzeit (Ts) ist, andernfalls Ausgeben eines Nicht-Sicher-Starten-Signals (ns).

In weiterer Ausgestaltung erfolgt das Bilden der zeitdiskreten Ausgangsspannungs-Messwerte durch Erzeugen einer Folge von zeitdiskreten Eingangsspannungs-Messwerten durch Abtasten des Kurvenverlaufs der gemessenen Spannung mit einer vorgegebenen Abtastrate, Berechnen der zeitdiskreten Ausgangsspannungs-Messwerte aus den zeitdiskreten Eingangsspannungs-Messwerten durch Messwert-Mittelwertbildung mit Abtastratenverminderung und Berechnen von gefilterten Spannungs-Messwerten durch digitale Tiefpass-Filterung von dezimierten Spannungs-Messwerten.

Mittels Verfahren der digitalen Signalverarbeitung erfolgt somit nach Abtastung des Kurvenverlaufs der gemessenen Spannung eine Transformation der zeitdiskreten Eingangsspannungs-Messwerte über dezimierte Spannungs-Messwerte und gefilterte Spannungs-Messwerte in die zeitdiskreten Ausgangsspannungs-Messwerte.

Die Messwert-Mittelwertbildung kann in mehreren Stufen durchgeführt werden, wobei gleichzeitig eine Abtastratenverminderung erfolgt.

Zum einen können dadurch die Messung verfälschende Rauschanteile bereits deutlich verringert werden, zum anderen wird durch eine fortlaufende Zusammenfassung der zeitdiskreten Eingangsspannungs-Messwerte zu einem Mittelwert die Anzahl der weiter zu verarbeitenden Abtastwerte pro Zeiteinheit gesenkt, was der Verminderung der Abtastrate entspricht und wodurch geringere Anforderungen an die Rechenleistung und Speicherbedarf für die Ausführung nachfolgender Signalverarbeitungsalgorithmen gestellt werden.

Mit Vorteil umfasst die Messwert-Mittelwertbildung eine erste Mittelwertbildung, wobei überlappungsfrei aufeinanderfolgend jeweils über eine Anzahl N von den zeitdiskreten Eingangsspannungs-Messwerten die dezimierten Spannungs-Messwerte gebildet werden.

Dabei werden blockweise und ohne Block-Überdeckung aufeinanderfolgend jeweils N zeitdiskrete Eingangsspannungs-Messwerte zur Berechnung eines für den jeweiligen Block geltenden linearen Mittelwertes herangezogen. Die Zusammenfassung der jeweils N zeitdiskreten Eingangsspannungs-Messwerte führt auf eine Folge von dezimierten Spannungs-Messwerten, die den jeweiligen Mittelwert repräsentieren und die einen deutlich verringerten Rauschanteil aufweisen.

Weiter umfasst die Messwert-Mittelwertbildung eine zweite Mittelwertbildung, wobei überlappungsfrei aufeinanderfolgend jeweils über eine Anzahl M von den gefilterten Spannungs-Messwerten die zeitdiskreten Ausgangsspannungs-Messwerte gebildet werden und die Anzahl M an das Zeitverhalten der zeitdiskreten Ausgangsspannungs-Messwerte (Vi) adaptiv angepasst wird.

Es findet somit eine weitere blockweise lineare Mittelwertbildung aus überlappungsfrei aufeinanderfolgenden gefilterten Spannungsmesswerten statt, wobei allerdings im Vergleich zu der ersten Mittelwertbildung die Anzahl M der blockweise zusammengefassten gefilterten Spannungs-messwerte an den zeitlichen Verlauf der zeitdiskreten Ausgangsspannungs-Messwerte in der Weise adaptiv angepasst werden kann.

Um den Rechenaufwand zu reduzieren und dennoch eine möglichst ge-naue digitale Abbildung des kapazitätsaufladenden Spannungsverlaufs zu erhalten, wird beispielsweise bei einer schnellen zeitlichen Änderung der zeitdiskreten Ausgangsspannungs-Messwerte eine kürzere Blocklänge gewählt, also eine geringere Anzahl M von gefilterten Spannungsmesswerten zu einem linearen Mittelwert zusammengefasst, als bei geringer zeitlicher Änderung der zeitdiskreten Ausgangsspannungs-Messwerte.

Bevorzugt erfolgt die adaptive Anpassung durch eine erste Regelung, welche die Anzahl M in Abhängigkeit des Differenzenquotienten zweiter Ordnung ($V''_i$) der zeitdiskreten Ausgangsspannungs-Messwerte ($V_i$) derart einstellt, dass der Differenzenquotient zweiter Ordnung ($V''_i$) der zeitdiskreten Ausgangsspannungs-Messwerte ($V_i$) innerhalb eines zulässigen ersten Wertebereichs liegt.

Der Differenzenquotient zweiter Ordnung der zeitdiskreten Ausgangsspannungs-Messwerte wird als Maßstab und Anpassungskriterium herangezogen, um das Zeitverhalten der zeitdiskreten Ausgangsspannungs-Messwerte möglichst genau an den wahren zeitlichen Verlauf der gemessenen Spannung anzupassen.

Für den Differenzenquotient zweiter Ordnung der zeitdiskreten Ausgangsspannungs-Messwerte wird ein zulässiger erster Wertebereich festgelegt, innerhalb dessen sich dieser Differenzenquotient bewegen darf. Mittels einer Rückkopplung in der ersten Regelung wird der auf Basis der zeitdiskreten Ausgangsspannungs-Messwerte berechnete Differenzenquotient zweiter Ordnung zurückgeführt und bewertet, wobei die Anzahl M der blockweise zusammenzufassenden gefilterten Spannungsmesswerte so eingestellt wird, dass dieser Differenzenquotienten innerhalb des zulässigen ersten Wertebereichs liegt.

Mit Vorteil wird zum Berechnen des effektiven tau-Wertes fortlaufend aus jeweils drei verschachtelt zusammengefassten Zeitkonstanten ein verschachtelter tau-Mittelwert und ein tau-Differenzenquotient zweiter Ordnung berechnet, wobei eine zweite Regelung erfolgt, welche die Anzahl M in Abhängigkeit des tau-Differenzenquotienten zweiter Ordnung derart einstellt, dass der tau-Differenzenquotient zweiter Ordnung innerhalb eines zulässigen zweiten Wertebereichs liegt, und anschließend eine Mittelwertbildung über eine Anzahl K der verschachtelten tau-Mittelwerte zur Berechnung des effektiven tau-Wertes erfolgt.

Weiter kann aus einem der gespeicherten, zeitdiskreten Spannungs-Messwerte, dem jeweils zugehörigem Zeitpunkt und dem effektiven tau-Wert ein stationärer Endwert (Voll-Ladespannung) der Kondensatorspannung berechnet werden zu

$$Vstat = Vi/\left(1 - e^{-ti/tau\_eff}\right)$$

Die der Erfindung zugrunde liegende Aufgabe wird in Verbindung mit den Merkmalen in dem Oberbegriff des Anspruchs 8 ebenfalls gelöst durch Vorgeben einer Ziel-Ladegeschwindigkeit, die in einem Ziel-Zeitpunkt an in dem ungeerdeten Stromversorgungssystem vorhandenen Netzkapazitäten erreicht werden soll, Berechnen einer zweiten Wartezeit ausgehend von dem T2-Zeitpunkt (t=T2) als Differenz zwischen dem Ziel-Zeitpunkt und dem T2-Zeitpunkt aus dem effektiven tau-Wert und dem Quotienten aus der Ziel-Ladegeschwindigkeit und dem ermittelten Differenzenquotienten erster Ordnung zu dem T2-Zeitpunkt und Ausgeben eines Sicher-Starten-Signals, falls die zweite Wartezeit kleiner als eine vorgegebene Schnellstartzeit ist, andernfalls Ausgeben eines Nicht-Sicher-Starten-Signals.

Einschließlich des Verfahrensschrittes der Berechnung des effektiven tau-Wertes stimmt die zweite Variante des erfindungsgemäßen Verfahrens nach Anspruch 8 mit den anfänglichen Verfahrensschritten der ersten Variante gemäß Anspruch 1 überein.

In der zweiten Variante wird alternativ zur ersten Variante als Eingangsparameter nicht der Ziel-Ladezustand, sondern eine Ziel-Ladegeschwindigkeit vorgegeben, die einen für die Isolationswiderstandsmessung gültigen, hinreichend stationären Ladezustand der Kondensatoren widerspiegelt. Die Ziel-Ladegeschwindigkeit entspricht dem Differenzenquotienten erster Ordnung der Ziel-Ladespannung und ist damit mit dem Ziel-Zeitpunkt verknüpft. In Kenntnis des bereits ermittelten und gespeicherten Differenzenquotienten erster Ordnung zu dem T2-Zeitpunkt (t=T2) wird eine Zeitdifferenz zu dem gespeicherten T2-Zeitpunkt als zweite Wartezeit berechnet.

Auch die weiteren Ausgestaltungen in den auf die zweite Variante nach Anspruch 8 unmittelbar oder mittelbar rückbezogenen Ansprüchen entsprechen den für die erste Variante geltenden Ausführungen.

Die dem erfindungsgemäßen Verfahren in erster und zweiter Variante zugrundeliegende Idee besteht somit darin, einen für die Berechnung des Isolationswiderstands gültigen Ladezustand, beschrieben beispielsweise durch Ladeparameter wie die Ladezeit oder die Voll-Ladespannung, in vorteilhafter Weise auf der Grundlage des laufenden Lade- oder Entladevorgangs vorhersagen zu können - im Gegensatz zu aus dem Stand der Technik bekannten Verfahren, bei denen die Ladeparameter erst dann bekannt sind, wenn der Lade-/Entladevorgang tatsächlich abgeschlossen ist. So ist es mit den erfindungsgemäß berechneten Wartezeiten nicht erforderlich, dass eine Auswerteeinheit (Controller) ständig in energieaufwendiger Weise den AD-Umsetzer abfragen muss, um den aktuellen Ladezustand zu erfragen.

Weitere vorteilhafte Ausgestaltungsmerkmale ergeben sich aus der nachfolgenden Beschreibung und den Zeichnungen, die eine bevorzugte Ausführungsform der Erfindung an Hand von Beispielen erläutern. Es zeigen:

**Fig. 1:** die Bestimmung eines Isolationswiderstands in einem ungeerdeten Stromversorgungssystem nach dem Stand der Technik,

**Fig. 2A, 2B:** ein Ersatzschaltbild zur Aufladung/Entladung eines Kondensators,

**Fig. 3A, 3B:** einen zeitlichen Kurvenverlauf einer Kondensatorspannung bei Aufladung/Entladung des Kondensators,

**Fig. 4:** Differentialquotienten erster und zweiter Ordnung des Spannungsverlaufs nach **Fig. 3A,**

**Fig. 5:** eine negative Zeitkonstante als Quotient aus den Differentialquotienten nach **Fig. 4,**

**Fig. 6:** ein Ablaufdiagramm des erfindungsgemäßen Verfahrens mit Vorgabe eines Ziel-Ladezustands (erste Variante),

**Fig. 7:** ein Ablaufdiagramm des erfindungsgemäßen Verfahrens mit Vorgabe einer Ziel-Ladegeschwindigkeit (zweite Variante),

**Fig. 8:** ein Ablaufdiagramm zum Bilden und Speichern der Ausgangsspannungs-Messwerte mit Messwert-Mittelwertbildung,

**Fig. 9:** ein Ablaufdiagramm zum Berechnen des effektiven tau-Wertes mit Zeitkonstanten-Mittelwertbildung,

**Fig. 10:** eine Darstellung von verschachtelten tau-Mittelwerten,

**Fig. 11:** eine zweite Mittelwertbildung schematisch mit adaptiver Anpassung und

**Fig. 12:** eine Berechnung der Differenzenquotienten erster und zweiter Ordnung.

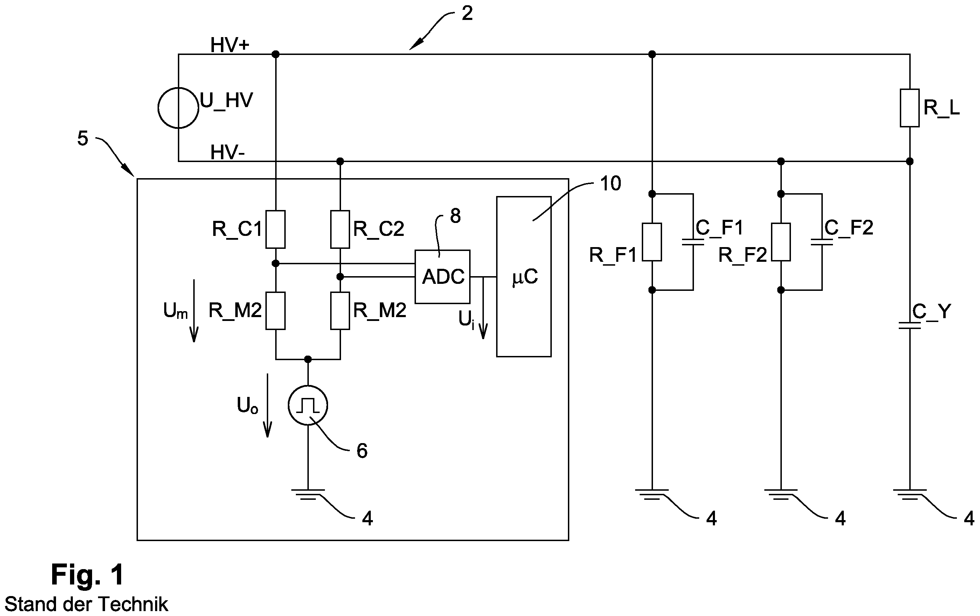

**Fig. 1** zeigt in einem funktionalen Blockdiagramm die Bestimmung eines Isolationswiderstands R_F1, R_F2 in einem ungeerdeten Stromversorgungssystem 2 nach dem Stand der Technik.

Das ungeerdete Stromversorgungssystem 2 ist hier beispielhaft als Bordnetz eines Elektrofahrzeugs ausgelegt und besteht im Wesentlichen aus den beiden aktiven Leitern HV+ und HV-, über die eine Gleichspannungsquelle U_HV die Last R_L mit Energie versorgt. Neben den zu bestimmenden Isolationswiderständen R_F1, R_F2 ist das ungeerdete Stromversorgungssystem 2 durch die (natürlichen) Netzableitkapazitäten C_F1, C_F2 charakterisiert, die sich zwischen dem jeweiligen aktiven Leiter HV+, HV- gegen Erde 4 ausbilden und hier als konzentrierte Bauelemente dargestellt sind. Y-Kondensatoren C_Y, die der Unterdrückung von (Gleichtakt-)Störungen dienen, wirken zwischen der Last R_L und Erde 4.

Zur Überwachung der Isolationswiderstände R_F1, R_F2 ist ein Isolationsüberwachungsgerät (Insulation Monitoring Device IMD) 5 installiert, welches einen Messimpulsgenerator 6 aufweist, der über einen Ankoppelzweig mit Ankoppelwiderständen R_C1, R_C2 und Messwiderständen R_M1, R_M2 eine Messspannung $U_0$ jeweils zwischen jeweils einen der aktiven Leiter HV+, HV- und Erde 4 in das ungeerdete Stromversorgungssystem 2 einspeist. Die Messspannung $U_0$ setzt sich aus zeitlich aufeinanderfolgenden Rechteck-Messimpulsen zusammen. An den Messwiderständen R_M1, R_M2 wird jeweils eine gemessene Spannung $U_m$ erfasst, die in einem Analog-Digital-Umsetzer 8 (ADC) durch Abtasten mit einer Abtastrate $f_S$ in eine Folge von zeitdiskreten Eingangsspannungs-Messwerten $U_i$ umgesetzt wird, welche einer nachfolgenden digitalen Signalverarbeitungseinheit 10 zur Bestimmung der Isolationswiderstände R_F1, R_F2 zugeführt wird.

Das ungeerdete Stromversorgungssystem 2 sowie das Isolationsüberwachungsgerät 5 stellen damit die Anwendungsumgebung für das erfindungsgemäße Verfahren 30, 40 zur schnellen Isolationswiderstandsmessung in der ersten und zweiten Variante dar.

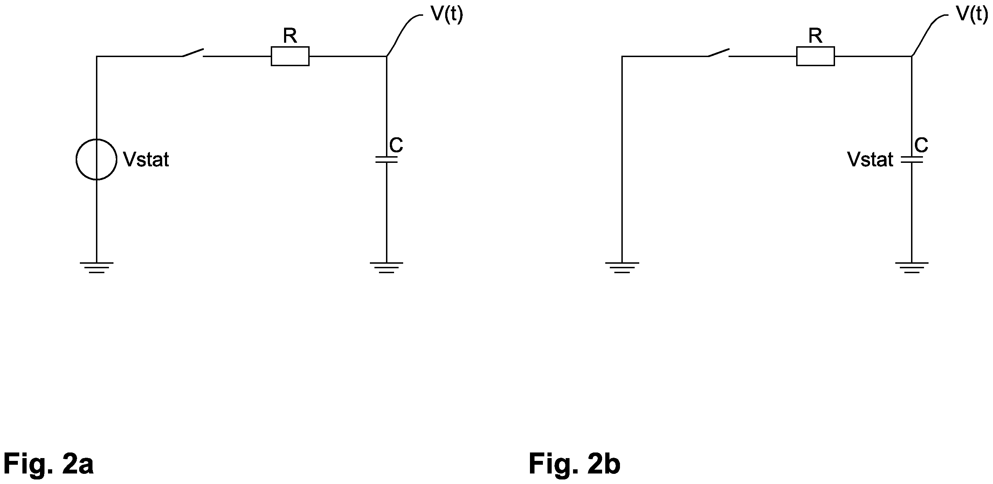

In den **Fig. 2A und 2B** ist jeweils ein Ersatzschaltbild zur Aufladung/Entladung eines Kondensators C über einen Widerstand R dargestellt. Der Kondensator C kann in der vorliegenden Betrachtung als Parallelschaltung aus den Netzableitkapazitäten C_F1 und C_F2 und den Y-Kondensatoren C_Y aus **Fig. 1** aufgefasst werden und wird auf einen stationären Endwert Vstat (Voll-Ladespannung, Quellenspannung) aufgeladen.

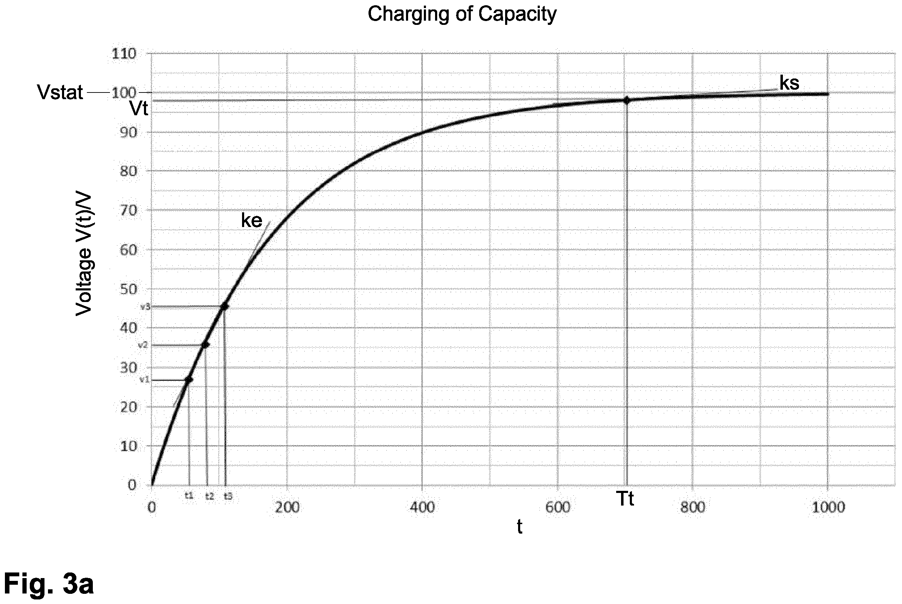

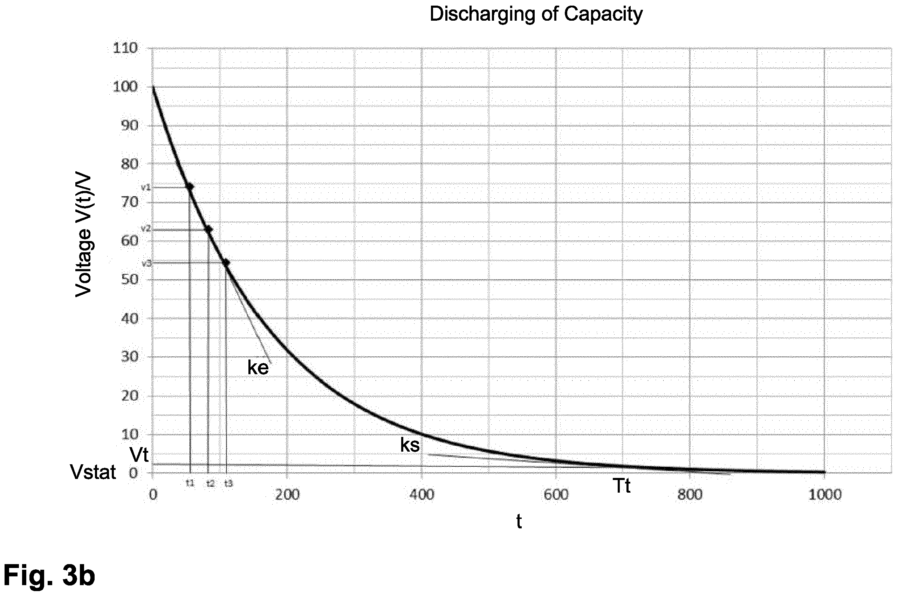

Die **Fig. 3A** und **Fig. 3B** zeigen den sich bei der Aufladung und der Entladung des Kondensators nach den **Fig. 2A** und **2B** einstellenden zeitlichen Verlauf der Kondensator(Lade-/Entlade-)Spannungen V(t) in zeitkontinuierlicher Darstellung.

Der Kurvenverlauf folgt einer Exponentialfunktion, welche sich asymptotisch der Quellenspannung Vstat bzw. dem Wert Null nähert. Eingezeichnet sind die den Zeitpunkten t=t1, t2, t3, Tt zugeordneten Kondensatorspannungen V(t) =V1, V2, V3, Vt.

Zur Veranschaulichung der unterschiedlichen Ladegeschwindigkeiten, also der zeitlichen Änderung (Differentialquotient) der Kondensatorspannung V(t), in einer Einschwingphase und einer Sättigungsphase sind zusätzlich zwei Tangenten ke (Einschwingphase) und ks (Sättigungsphase) eingezeichnet. In zeitdiskreter Darstellung entsprechen diese zeitlichen Ableitungen den Differenzenquotienten erster Ordnung.

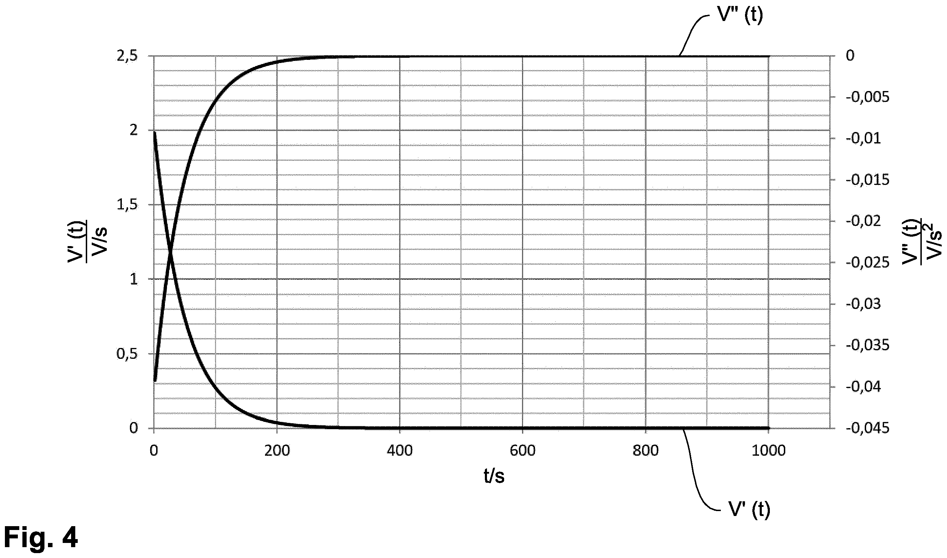

**Fig. 4** zeigt die Differentialquotienten erster und zweiter Ordnung V'(t), V''(t) (erste und zweite Ableitungen) des Spannungsverlaufs der Kondensatorspannung V(t) nach **Fig. 3A.** Man erkennt, dass die Differentialquotienten erster und zweiter Ordnung V'(t), V''(t) wiederum einen exponentiellen Verlauf aufweisen und entgegengesetzte Vorzeichen besitzen.

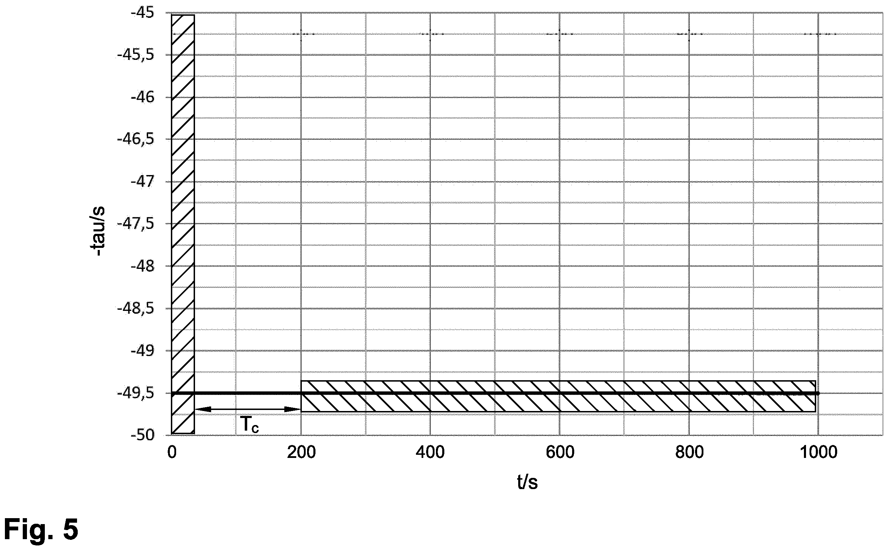

Abgeleitet aus der Darstellung der Differentialquotienten V'(t), V''(t) in **Fig. 4** zeigt die **Fig. 5** den Quotienten V'(t)/V''(t) aus dem Differentialquotient erster Ordnung V'(t) dividiert durch den Differentialquotient zweiter Ordnung V''(t).

Dieser Quotient V'(t)/V''(t) entspricht der negativen Zeitkonstanten -tau

$$\frac{V'(t)}{V''(t)} = -RC = -tau$$

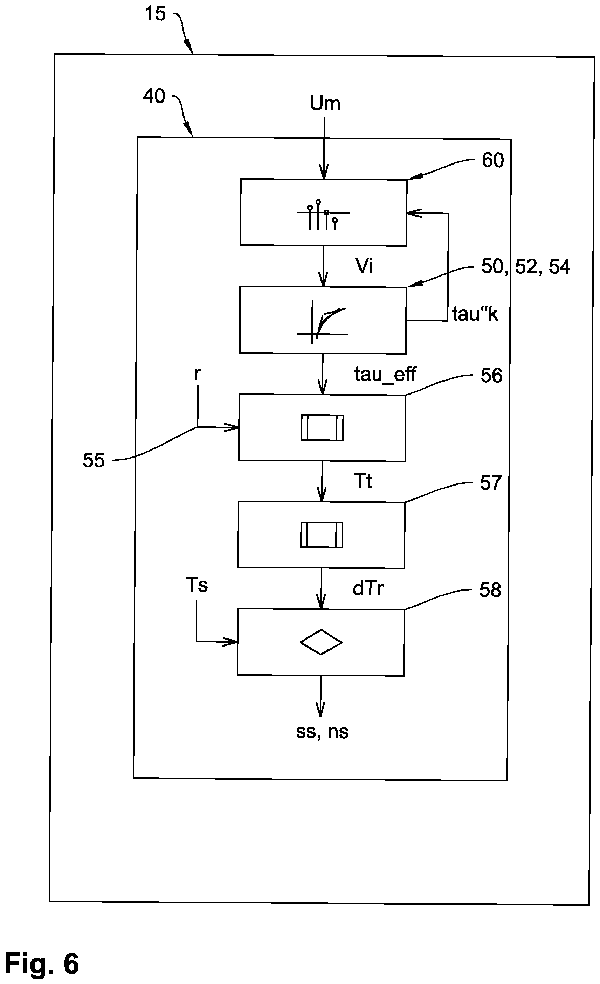

**Fig. 6** zeigt ein Ablaufdiagramm des erfindungsgemäßen Verfahrens 40 mit Vorgabe 55 eines Ziel-Ladezustands r (erste Variante) innerhalb des Verfahrens 15 zur Bestimmung des Isolationswiderstands.

Ausgehend von dem zeitkontinuierlichen Verlauf der gemessenen Spannung $U_m$ wird in Block 60 eine Folge von zeitdiskreten Ausgangsspannungs-Messwerte $V_i$ gebildet und gespeichert.

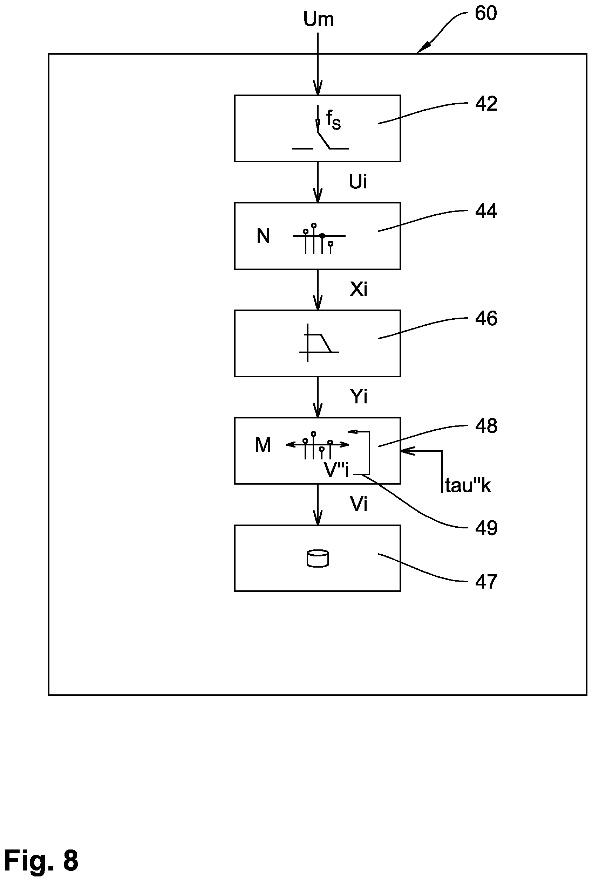

**Fig. 8** beschreibt die dazu in Block 60 erforderlichen Verfahrensschritte zum Bilden und Speichern der Ausgangsspannungs-Messwerte Vi in einem Ablaufdiagramm.

Durch Abtasten 42 des Kurvenverlaufs der gemessenen Spannung $U_m$ mit einer Abtastfrequenz $f_S$ mittels eines Analog-Digital-Umsetzers wird eine Folge von zeitdiskreten Eingangsspannungs-Messwerten $U_i$ für die nachfolgenden digitalen Signalverarbeitungsschritte erzeugt.

Das Berechnen von zeitdiskreten Ausgangsspannungs-Messwerten $V_i$ aus den zeitdiskreten Eingangsspannungs-Messwerten $U_i$ erfolgt durch eine zweitstufige Messwert-Mittelwertbildung 44, 48 mit einer ersten Mittelwertbildung 44 und einer zweiten Mittelwertbildung 48 und einer zwischen der ersten Mittelwertbildung 44 und der zweiten Mittelwertbildung 48 durchgeführten digitalen Tiefpassfilterung 46.

Bei der ersten Mittelwertbildung 44 wird für überlappungsfrei aufeinanderfolgende Blöcke mit jeweils einer Anzahl N von den zeitdiskreten Eingangsspannungs-Messwerten $U_i$ jeweils ein linearer zeitlicher Mittelwert gebildet, sodass als Ausgangssignal der ersten Mittelwertbildung 44 eine Folge von dezimierten Spannungs-Messwerten $X_i$ erscheint. Die Anzahl N der zu einem Block zusammenzufassenden Eingangsspannungs-Messwerte $U_i$ ist dabei voreinstellbar, bleibt aber während des Verfahrensablaufs konstant.

Durch die nachfolgende digitale Tiefpass-Filterung 46 der dezimierten Spannungsmesswerte $X_i$ wird eine Folge von gefilterten Spannungs-Messwerten $Y_i$ berechnet.

In einer zweiten Mittelwertbildung 48 werden analog zu der ersten Mittelwertbildung 44 zunächst überlappungsfrei aufeinanderfolgende Blöcke mit einer Anzahl M von den gefilterten Spannungs-Messwerten $Y_i$ gebildet. Für jeden Block wird dann ein linearer zeitlicher Mittelwert berechnet, der die Folge von zeitdiskreten Ausgangsspannungs-Messwerten $V_i$ ergibt.

Allerdings wird im Unterschied zu der ersten Mittelwertbildung 44 bei der zweiten Mittelwertbildung 48 die Anzahl M der zusammenzufassenden gefilterten Spannungs-Messwerte $Y_i$ an das Zeitverhalten der zeitdiskreten Ausgangsspannungs-Messwerte $V_i$ adaptiv angepasst.

Diese adaptive Anpassung berücksichtigt die zeitliche Änderung (Änderungsgeschwindigkeit) der zeitdiskreten Ausgangsspannungs-Messwerte $V_i$. Als Kriterium für die zeitliche Änderung wird vorzugsweise der Wert des Differenzenquotienten zweiter Ordnung $V''_i$ herangezogen.

Mittels einer ersten Regelung 49 wird das Ergebnis einer Berechnung des Differenzenquotienten zweiter Ordnung $V''_i$ zurückgekoppelt und mit einem zulässigen ersten Wertebereich, der beispielsweise durch die Grenzen [0.5, 2] vorgegeben wird, verglichen. Die Anzahl M der zusammenzufassenden gefilterten Spannungs-Messwerte $Y_i$ wird durch diese erste Regelung 49 so eingestellt, dass der Differenzenquotient zweiter Ordnung $V''_i$ innerhalb des zulässigen ersten Wertebereichs liegt und somit davon ausgegangen werden kann, dass die zeitdiskreten Ausgangsspannungs-Messwerte $V_i$ den gemessenen Spannungsverlauf $U_m$ richtig wiedergeben.

Eine schnelle zeitliche Änderung der zeitdiskreten Ausgangsspannungs-Messwerte $V_i$ kann somit durch eine geringere Anzahl M von für die jeweilige (Block-)Mittelung herangezogenen gefilterten Spannungs-Messwerten $Y_i$ berücksichtigt werden, als dies bei einer langsamen zeitlichen Änderung der zeitdiskreten Ausgangsspannungs-Messwerte $V_i$ erforderlich wäre. Statt der Berechnung von wenigen Mittelwerten über große Blocklängen mit vielen gefilterten Spannungs-Messwerten $Y_i$ (bei einer langsamen zeitlichen Änderung) werden (Block-)Mittelungen über kleine Blocklängen mit wenigen gefilterten Spannungs-Messwerten $Y_i$ (bei einer schnellen zeitlichen Änderung) vorgenommen, um mit den zeitdiskreten Ausgangsspannungs-Messwerten $V_i$ die gemessene Spannung $U_m$ möglichst genau und hinsichtlich des Rechenaufwands und der Speicherkapazität 47 möglichst effizient abzubilden.

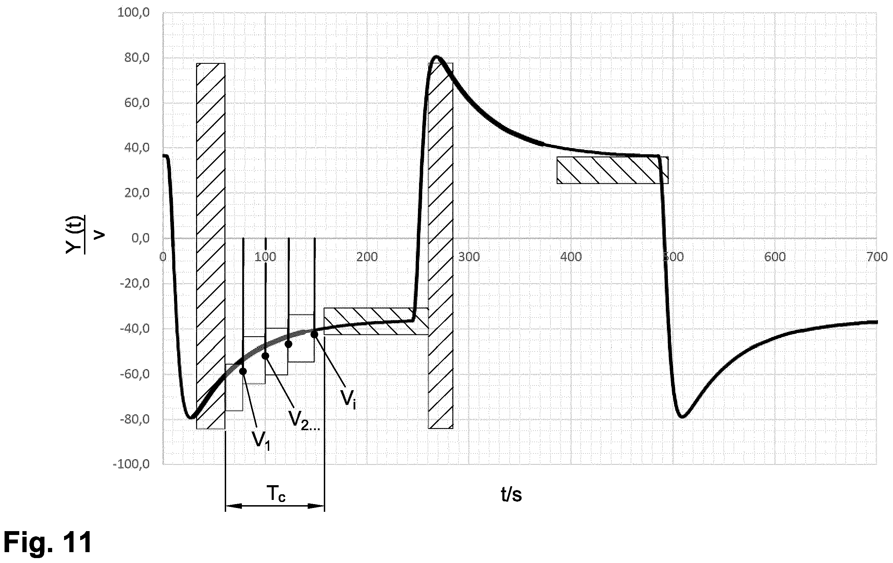

Im Detail verdeutlicht Fig. 11 bei der zweiten Mittelwertbildung 48 schematisch eine adaptive Anpassung der Anzahl M der in die (Block-)Mittelung einzubeziehenden gefilterten Spannungs-Messwerte $Y_i$. Die gefilterten (zeitdiskreten) Spannungs-Messwerte $Y_i$ sind in dieser Darstellung vereinfachend durch ein (fiktives) zugrundeliegendes zeitkontinuierliches gefiltertes Messsignal Y(t) interpoliert. Als Ausgangsgröße der zweiten Mittelwertbildung 48 mit der ersten Regelung 49 ergibt sich die Folge der zeitdiskreten Ausgangsspannungs-Messwerte $V_i$.

Zu erkennen ist, dass innerhalb des Berechnungszeitraums $T_c$ bei schneller Signaländerung (steiler Anstieg des Kurvenverlaufs) eine geringere Anzahl M von gefilterten Spannungs-Messwerten $Y_i$ (entspricht einer kurzen Blocklänge zur Berechnung von $V_1$) in die blockweise Berechnung des jeweiligen (Block-)Mittelwertes eingeht als bei einer langsamen Signaländerung (flacher Kurvenverlauf und längere Blocklängen bei $V_2$ bis $V_i$).

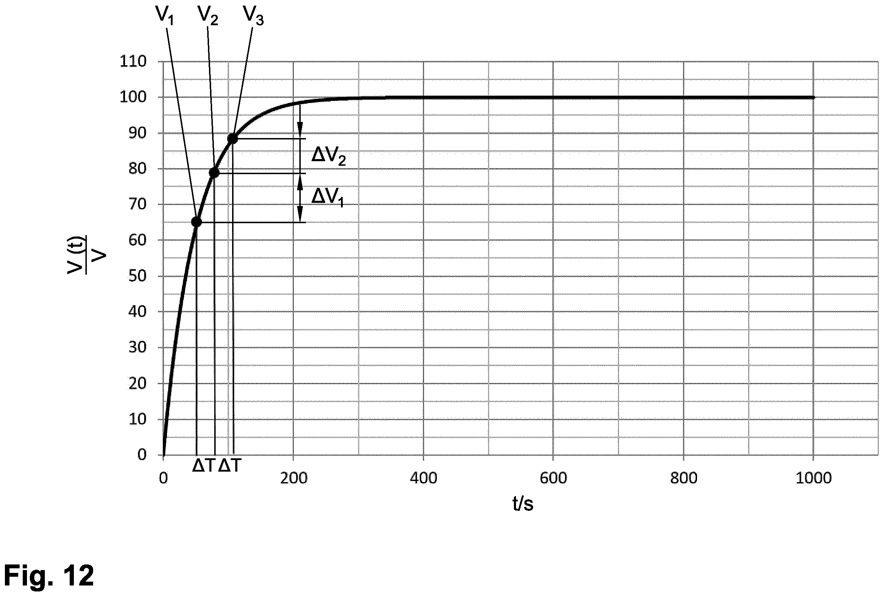

Fig. 12 zeigt die Berechnung der Differenzenquotienten erster Ordnung $V'_i$ und zweiter Ordnung $V''_i$. Für zeitdiskrete Signale ergibt sich beispielhaft für die dargestellten drei zeitlich aufeinanderfolgenden zeitdiskreten Ausgangsspannungs-Messwerte $V_i=\{V1, V2, V3\}$ mit

$$\Delta V1 = V2 - V1 \; , \; \Delta V2 = V3 - V2$$

und

$$V'_1 = \Delta V1/\Delta T \; , \; V'_2 = \Delta V2/\Delta T$$

sowie

$$V''_1 = \frac{V'_2 - V'_1}{\Delta T}$$

die Zeitkonstante $tau_1$ zu

$$tau_1 = -\frac{V'_1}{V''_1}$$

$$tau_1 = -\frac{\Delta V1}{\Delta V2 - \Delta V1} * \Delta T = -\frac{V2 - V1}{(V3 - V2) - (V2 - V1)} * \Delta T$$

Abweichend davon kann auch statt des Differenzenquotienten erster Ordnung für das Wertepaar $\{V1, V2\}$ im Zähler des negativen Quotienten auch der Differenzenquotient erster Ordnung für das Wertepaar $\{V2, V3\}$ oder der Mittelwert beider Wertepaare gemäß

$$tau_1 = -\frac{\frac{\Delta V2 + \Delta V1}{2}}{\Delta V2 - \Delta V1} * \Delta T = -\frac{(V3 - V1)/2}{(V3 - V2) - (V2 - V1)} * \Delta T$$

verwendet werden.

Zurückkommend auf **Fig. 6** erfolgt auf der Grundlage der aufbereiteten zeitdiskreten Ausgangsspannungs-Messwerte $V_i$ die Berechnung von Zeitkonstanten $tau_i$ in den Blöcken 50, 52, aus denen dann in Block 54 ein effektiver tau-Wert tau_eff berechnet wird.

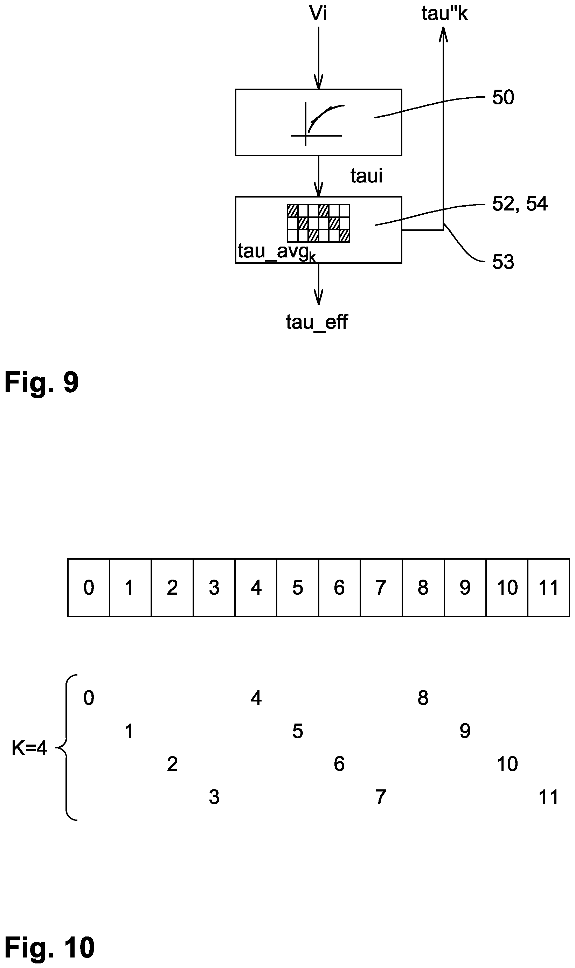

**Fig. 9** beschreibt die dazu in den Blöcken 50, 52,54 erforderlichen Verfahrensschritte mit Zeitkonstanten-Mittelwertbildung.

Zunächst erfolgt das Berechnen 50 von Zeitkonstanten $tau_i$ als negativer Quotient aus dem Differenzenquotient erster Ordnung $V'_i$ und dem Differenzenquotient zweiter Ordnung $V''_i$ von zeitlich aufeinanderfolgenden zeitdiskreten Ausgangsspannungs-Messwerten $V_i$ wie oben beschrieben.

Diese fortlaufende Berechnung der Differenzenquotienten erster Ordnung $V'_i$ und zweiter Ordnung $V''_i$ sowie die Quotientenbildung $V'_i/V''_i$ erstreckt sich über einen Berechnungszeitraum $T_c$ **(Fig. 5)** innerhalb einer Einschwingphase des Rechteck-Messimpulses. Vorzugsweise reicht der Berechnungszeitraum $T_c$ dabei von der Beendigung des Einschwingvorgangs des digitalen Tiefpassfilters 46 bis zu Beginn der Sättigungsphase der Kapazitätsaufladung.

Nach dem Berechnen 50 der Folge von Zeitkonstanten $tau_i$ erfolgt eine Berechnung 54 des effektiven tau-Wertes tau_eff mittels fortlaufender Berechnung 52 eines verschachtelten tau-Mittelwertes $tau\_avg_k$ und eines tau-Differenzenquotienten zweiter Ordnung $tau''_k$ aus jeweils drei verschachtelt zusammengefassten Zeitkonstanten $tau_i$.

Zudem wird eine zweite Regelung 53 ausgeführt, welche die Anzahl M der in die zweite Mittelwertbildung 48 einzubeziehenden gefilterten Spannungsmesswerten $Y_i$ an den zeitlichen Verlauf der verschachtelt gebildeten tau-Mittelwerte $tau\_avg_k$ anpasst. Prinzipiell beruht die zweite Regelung 53 auf dem gleichen Mechanismus wie die erste Regelung 49, verwendet aber als Vergleichsgröße die zeitliche Änderung der tau-Mittelwerte $tau\_avg_k$ statt der zeitdiskreten Ausgangsspannungs-Messwerte $V_i$. Durch Rückführung des tau-Differenzenquotienten zweiter Ordnung $tau''_k$ und Vergleich mit einem zulässigen zweiten Wertebereich wird die Anzahl M derart eingestellt, dass der tau-Differenz-

enquotient zweiter Ordnung tau"$_k$ innerhalb des zulässigen zweiten Wertebereichs liegt.

**Fig. 10** zeigt eine Darstellung der verschachtelten tau-Mittelwerte tau_avg$_k$. Aus der vorangegangenen Berechnung 50 steht ein Feld mit beispielsweise 12 Zeitkonstanten tau$_i$ mit den Indizes 0 bis 11 zur Verfügung. Aus diesem Feld von 12 Zeitkonstanten tau$_i$ werden K=4 verschachtelte tau-Mittelwerte tau_avg$_k$ gebildet, die jeweils drei Zeitkonstanten tau$_i$ umfassen. So wird in diesem Beispiel aus den Zeitkonstanten tau$_i$ mit den Indizes 0, 4, 8 ein erster verschachtelter tau-Mittelwert tau_avg$_1$ gebildet, aus den Zeitkonstanten tau$_i$ mit den Indizes 1, 5, 9 ein zweiter verschachtelter tau-Mittelwert tau_avg$_2$, usw.

Aus diesen 3-er Gruppen der Zeitkonstanten tau$_i$ wird neben dem tau-Mittelwert tau_avg$_k$ jeweils auch ein tau-Differenzenquotient zweiter Ordnung tau"$_k$ berechnet, der in der zweiten Regelung 53 als Anpassungskriterium zur Anpassung der Anzahl M in der zweiten Mittelwertbildung 48 dient.

Die Berechnung des tau-Differenzenquotienten zweiter Ordnung tau"$_k$ beruht dabei auf einer zur oben beschriebenen Berechnung des Differenzenquotienten zweiter Ordnung V"$_i$ der zeitdiskreten Ausgangsspannungs-Messwerte V$_i$ analogen Rechenvorschrift.

Anschließend erfolgt eine lineare Mittelwertbildung über eine Anzahl K der verschachtelten tau-Mittelwerte tau_avg$_k$, um den effektiven tau-Wert tau_eff als maßgebliche Zeitkonstante zur Berechnung 56 (Fig. 6) eines Ziel-Zeitpunktes Tt heranzuziehen.

Ist somit der effektive tau-Wert tau_eff bekannt, erfolgt in Block 56 der **Fig. 6** nach Vorgabe 55 des Ziel-Ladezustands r das Berechnen des Ziel-Zeitpunktes Tt.

Mit dem Ladezustand r=Vt/Vstat als Verhältnis einer in diesem Ziel-Ladezustand erreichten Ziel-Ladespannung Vt zu einem stationären Endwert Vstat (Voll-Ladespannung) der Kondensatorspannung folgt ausgehend von

$$Vt = Vstat * \left(1 - e^{-Tt/tau\_eff}\right)$$

$$r = Vt/Vstat = 1 - e^{-Tt/tau\_eff}$$

$$Tt = tau\_eff * ln(1 - r)$$

Die erste Wartezeit dTr beträgt dann als Differenz zwischen dem Ziel-Zeitpunkt Tt und dem aktuellen Zeitpunkt T3 (Block 57)

$$dTr = Tt - T3$$

Schließlich wird in Block 58 geprüft, ob die ermittelte erste Wartezeit dtr kleiner als eine vorgegebene Schnellstartzeit Ts ist. Falls die erste Wartezeit dtr kleiner als eine vorgegebene Schnellstartzeit Ts ist, die Schnellstart-Anforderung also erfüllt ist, wird ein Sicher-Starten-Signal ss ausgegeben, andernfalls ein Nicht-Sicher-Starten-Signal ns als Warnhinweis.

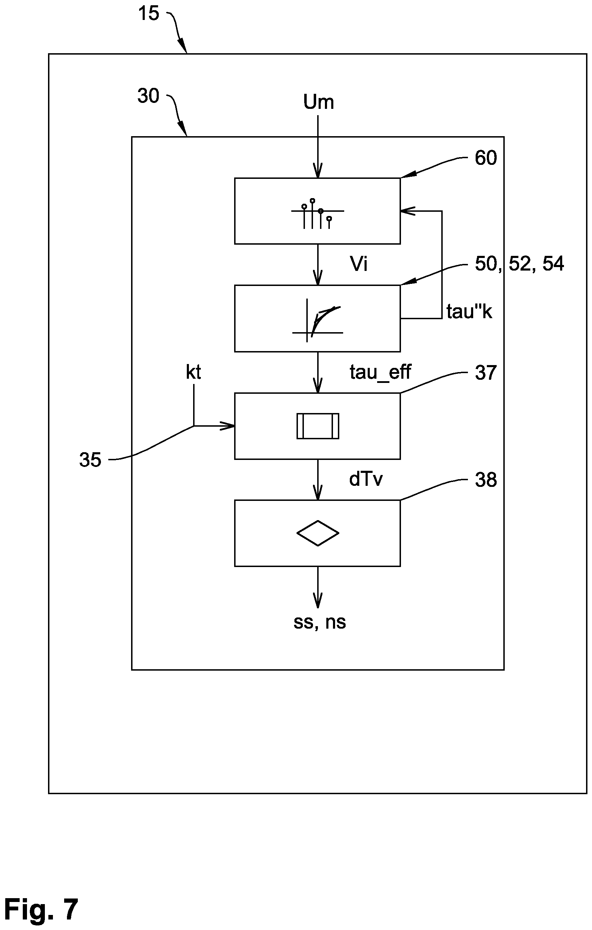

**Fig. 7** zeigt ein Ablaufdiagramm des erfindungsgemäßen Verfahrens mit Vorgabe 35 einer Ziel-Ladegeschwindigkeit kt (zweite Variante) innerhalb des Verfahrens 15 zur Bestimmung des Isolationswiderstands.

Wie in der ersten Variante nach **Fig. 6** wird in dem Block 60 zunächst die gemessene Spannung Um in Form der Folge von zeitdiskreten Ausgangsspannungs-Messwerte V$_i$ aufbereitet und gespeichert. Auch das Berechnen 50, 52 der Zeitkonstanten tau$_i$ sowie das Berechnen 54 des effektiven tau-Wertes tau_eff entsprechen den Verfahrensschritten der ersten Variante.

Der Unterschied zur ersten Variante liegt darin, dass anstelle des Ziel-Ladezustands 55, r eine Ziel-Ladegeschwindigkeit 35, kt vorgegeben wird.

Die Ziel-Ladegeschwindigkeit kt entspricht der zeitlichen Änderung der Kondensatorspannung gemäß

$$V't = dVt/dt$$

$$V't = -(Vstat/tau\_eff) * e^{-Tt/tau\_eff}$$

Gleichermaßen gilt für die bereits berechneten und abgespeicherten Spannungswerte V2 und V'2 zu dem T2-Zeitpunkt t=T2

$$V'2 = -(Vstat/tau\_eff) * e^{-T2/tau\_eff}$$

Hieraus folgt

$$V't/V'2 = e^{((T2-Tt)/tau\_eff)}$$

und mit

$$V't = kt$$

$$|T2 - Tt| = |tau\_eff * \ln(kt/V'2)| = dTr$$

als zweite Wartezeit dTr.

Auch hier erfolgt in Block 38 eine Prüfung, ob diese zweite Wartezeit dTr ausgehend von dem T2-Zeitpunkt T2 kleiner als eine vorgegebene Schnellstartzeit (Ts) ist und damit die Schnellstart-Anforderung erfüllt, sodass ein Sicher-Starten-Signals ss ausgegeben werden kann.

**Patentansprüche**

1. Verfahren (40) zur schnellen Isolationswiderstandsmessung für die Anwendung in einem Verfahren (15) zur Bestimmung des Isolationswiderstands (R_F1, R_F2) nach einem Impuls-Messverfahren in einem ungeerdeten Stromversorgungssystem (2), wobei eine aus zeitlich aufeinanderfolgenden Rechteck-Messimpulsen zusammengesetzte Messspannung ($U_0$) zwischen einen aktiven Leiter (HV+, HV-) des ungeerdeten Stromversorgungssystems (2) und Erde (4) mittels eines Messimpulsgenerators (6) über einen Ankoppelzweig mit einem Ankoppelwiderstand (R_C1, R_C2) und einem Messwiderstand (R_M1, R_M2) angelegt wird und ein zeitkontinuierlicher Kurvenverlauf einer über dem Messwiderstand (R_M1, R_M2) gemessenen Spannung ($U_m$) erfasst wird, umfassend die Verfahrensschritte:

   Bilden und Speichern einer Folge von zeitdiskreten Ausgangsspannungs-Messwerten ($V_i$) aus dem Kurvenverlauf der gemessenen Spannung ($U_m$),
   Berechnen von Zeitkonstanten (50, $tau_i$) als negativer Quotient aus einem Differenzenquotienten erster Ordnung ($V'_i$) und einem Differenzenquotienten zweiter Ordnung ($V''_i$) von an den zeitlich unmittelbar aufeinanderfolgenden Zeitpunkten (T1, T2, T3) gespeicherten, zeitdiskreten Ausgangsspannungs-Messwerten ($V_i$=V1, V2, V3) in einem Berechnungszeitraum ($T_c$) innerhalb einer Einschwingphase des Rechteck-Messimpulses,
   Berechnen eines effektiven tau-Wertes (54, tau_eff) durch Zeitkonstanten-Mittelwertbildung,
   **gekennzeichnet durch**
   Vorgeben (55) eines Ziel-Ladezustands (r) der in dem ungeerdeten Stromversorgungssystem vorhandenen Netzkapazitäten (C_F1, C_F2),
   Berechnen eines Ziel-Zeitpunktes (Tt), an dem die Netzkapazitäten (C_F1, C_F2) den Ziel-Ladezustand (r) erreicht haben werden, aus dem Ziel-Ladezustand (r) und dem effektiven tau-Wert (54, tau_eff), Berechnen einer ersten Wartezeit (dTr) ausgehend von dem aktuellen Zeitpunkt (T3) als Differenz zwischen dem Ziel-Zeitpunkt (Tt) und dem aktuellen Zeitpunkt (T3),
   Ausgeben eines Sicher-Starten-Signals (ss), falls die erste Wartezeit (dTr) kleiner als eine vorgegebene Schnellstartzeit (Ts) ist, andernfalls Ausgeben eines Nicht-Sicher-Starten-Signals (ns).

2. Verfahren nach Anspruch 1,
   **dadurch gekennzeichnet,**

   **dass** das Bilden der zeitdiskreten Ausgangsspannungs-Messwerte ($V_i$) erfolgt durch
   Erzeugen einer Folge von zeitdiskreten Eingangsspannungs-Messwerten ($U_i$) durch Abtasten (42) des Kurvenverlaufs der gemessenen Spannung ($U_m$) mit einer vorgegebenen Abtastrate,
   Berechnen der zeitdiskreten Ausgangsspannungs-Messwerte ($V_i$) aus den zeitdiskreten Eingangsspannungs-Messwerten ($U_i$) durch Messwert-Mittelwertbildung (44, 48) mit Abtastratenverminderung,
   Berechnen von gefilterten Spannungs-Messwerten ($Y_i$) durch digitale Tiefpass-Filterung (46) von dezimierten Spannungs-Messwerten ($X_i$).

3. Verfahren nach Anspruch 2,

**dadurch gekennzeichnet,**
**dass** die Messwert-Mittelwertbildung eine erste Mittelwertbildung (44) umfasst, wobei überlappungsfrei aufeinanderfolgend jeweils über eine Anzahl N von den zeitdiskreten Eingangsspannungs-Messwerten ($U_i$) die dezimierten Spannungs-Messwerte ($X_i$) gebildet werden.

4. Verfahren nach Anspruch 2 oder 3,
**dadurch gekennzeichnet,**
**dass** die Messwert-Mittelwertbildung eine zweite Mittelwertbildung (48) umfasst, wobei überlappungsfrei aufeinanderfolgend jeweils über eine Anzahl M von den gefilterten Spannungs-Messwerten ($Y_i$) die zeitdiskreten Ausgangsspannungs-Messwerte ($V_i$) gebildet werden und die Anzahl M an das Zeitverhalten der zeitdiskreten Ausgangsspannungs-Messwerte ($V_i$) adaptiv angepasst wird.

5. Verfahren nach Anspruch 4,
**dadurch gekennzeichnet,**
**dass** die adaptive Anpassung durch eine erste Regelung (49) erfolgt, welche die Anzahl M in Abhängigkeit des Differenzenquotienten zweiter Ordnung ($V''_i$) der zeitdiskreten Ausgangsspannungs-Messwerte ($V_i$) derart einstellt, dass der Differenzenquotient zweiter Ordnung ($V''_i$) der zeitdiskreten Ausgangsspannungs-Messwerte ($V_i$) innerhalb eines zulässigen ersten Wertebereichs liegt.

6. Verfahren nach Anspruch 4 oder 5,
**dadurch gekennzeichnet,**
**dass** in der Zeitkonstanten-Mittelwertbildung zum Berechnen des effektiven tau-Wertes (54, tau_eff) fortlaufend aus jeweils drei verschachtelt zusammengefassten Zeitkonstanten ($tau_i$) ein verschachtelter tau-Mittelwert ($tau\_avg_k$) und ein tau-Differenzenquotient zweiter Ordnung ($tau''_k$) berechnet werden (52), wobei eine zweite Regelung (53) erfolgt, welche die Anzahl M in Abhängigkeit des tau-Differenzenquotienten zweiter Ordnung ($tau''_k$) derart einstellt, dass der tau-Differenzenquotient zweiter Ordnung ($tau''_k$) innerhalb eines zulässigen zweiten Wertebereichs liegt, und anschließend eine Mittelwertbildung über eine Anzahl K der verschachtelten tau-Mittelwerte ($tau\_avg_k$) zur Berechnung des effektiven tau-Wertes (tau_eff) erfolgt.

7. Verfahren nach einem der Ansprüche 1 bis 6,
**dadurch gekennzeichnet,**
**dass** aus einem der gespeicherten, zeitdiskreten Spannungs-Messwerte ($V_i$=V1, V2, V3), dem jeweils zugehörigem Zeitpunkt (t1, t2, t3) und dem effektiven tau-Wert (tau_eff) ein stationärer Endwert (Vstat) der Kondensatorspannung berechnet wird.

8. Verfahren (30) zur schnellen Isolationswiderstandsmessung für die Anwendung in einem Verfahren (15) zur Bestimmung des Isolationswiderstands (R_F1, R_F2) nach einem Impuls-Messverfahren in einem ungeerdeten Stromversorgungssystem (2), wobei eine aus zeitlich aufeinanderfolgenden Rechteck-Messimpulsen zusammengesetzte Messspannung ($U_0$) zwischen einen aktiven Leiter (HV+, HV-) des ungeerdeten Stromversorgungssystems (2) und Erde (4) mittels eines Messimpulsgenerators (6) über einen Ankoppelzweig mit einem Ankoppelwiderstand (R_C1, R_C2) und einem Messwiderstand (R_M1, R_M2) angelegt wird und ein zeitkontinuierlicher Kurvenverlauf einer über dem Messwiderstand (R_M1, R_M2) gemessenen Spannung ($U_m$) erfasst wird, umfassend die Verfahrensschritte:

Bilden und Speichern einer Folge von zeitdiskreten Ausgangsspannungs-Messwerten ($V_i$) aus dem Kurvenverlauf der gemessenen Spannung ($U_m$),
Berechnen von Zeitkonstanten (50, $tau_i$) als negativer Quotient aus einem Differenzenquotienten erster Ordnung ($V'_i$) und einem Differenzenquotienten zweiter Ordnung ($V''_i$) von an den zeitlich unmittelbar aufeinanderfolgenden Zeitpunkten (T1, T2, T3) gespeicherten, zeitdiskreten Ausgangsspannungs-Messwerten ($V_i$=V1, V2, V3) in einem Berechnungszeitraum ($T_c$) innerhalb einer Einschwingphase des Rechteck-Messimpulses,
Berechnen eines effektiven tau-Wertes (54, tau_eff) durch Zeitkonstanten-Mittelwertbildung,
**gekennzeichnet durch**
Vorgeben (35) einer Ziel-Ladegeschwindigkeit (kt), die in einem Ziel-Zeitpunkt (Tt) an in dem ungeerdeten Stromversorgungssystem vorhandenen Netzkapazitäten (C_F1, C_F2) erreicht werden soll,
Berechnen einer zweiten Wartezeit (dTv) ausgehend von dem T2-Zeitpunkt (T2) als Differenz zwischen dem Ziel-Zeitpunkt (Tt) und dem T2-Zeitpunkt (T2) aus dem effektiven tau-Wert (54, tau_eff) und dem Quotienten aus der Ziel-Ladegeschwindigkeit (kt) und dem ermittelten Differenzenquotienten erster Ordnung ($V'2$) zu dem T2-Zeitpunkt (T2),

Ausgeben eines Sicher-Starten-Signals (ss), falls die zweite Wartezeit (dTv) kleiner als eine vorgegebene Schnellstartzeit (Ts) ist, andernfalls Ausgeben eines Nicht-Sicher-Starten-Signals (ns).

**9.** Verfahren nach Anspruch 8,
**dadurch gekennzeichnet,**

**dass** das Bilden der zeitdiskreten Ausgangsspannungs-Messwerte ($V_i$) erfolgt durch
Erzeugen einer Folge von zeitdiskreten Eingangsspannungs-Messwerten ($U_i$) durch Abtasten (42) des Kurvenverlaufs der gemessenen Spannung ($U_m$) mit einer vorgegebenen Abtastrate,
Berechnen der zeitdiskreten Ausgangsspannungs-Messwerte ($V_i$) aus den zeitdiskreten Eingangsspannungs-Messwerten ($U_i$) durch Messwert-Mittelwertbildung (44, 48) mit Abtastratenverminderung,
Berechnen von gefilterten Spannungs-Messwerten ($Y_i$) durch digitale Tiefpass-Filterung (46) von dezimierten Spannungs-Messwerten ($X_i$).

**10.** Verfahren nach Anspruch 9,
**dadurch gekennzeichnet,**
**dass** die Messwert-Mittelwertbildung eine erste Mittelwertbildung (44) umfasst, wobei überlappungsfrei aufeinanderfolgend jeweils über eine Anzahl N von den zeitdiskreten Eingangsspannungs-Messwerten ($U_i$) die dezimierten Spannungs-Messwerte ($X_i$) gebildet werden.

**11.** Verfahren nach 9 oder 10,
**dadurch gekennzeichnet,**
**dass** die Messwert-Mittelwertbildung eine zweite Mittelwertbildung (48) umfasst, wobei überlappungsfrei aufeinanderfolgend jeweils über eine Anzahl M von den gefilterten Spannungs-Messwerten ($Y_i$) die zeitdiskreten Ausgangsspannungs-Messwerte ($V_i$) gebildet werden und die Anzahl M an das Zeitverhalten der zeitdiskreten Ausgangsspannungs-Messwerte ($V_i$) adaptiv angepasst wird.

**12.** Verfahren nach Anspruch 11,
**gekennzeichnet durch**
die adaptive Anpassung durch eine erste Regelung (49) erfolgt, welche die Anzahl M in Abhängigkeit des Differenzenquotienten zweiter Ordnung ($V''_i$) der zeitdiskreten Ausgangsspannungs-Messwerte ($V_i$) derart einstellt, dass der Differenzenquotient zweiter Ordnung ($V''_i$) der zeitdiskreten Ausgangsspannungs-Messwerte ($V_i$) innerhalb eines zulässigen ersten Wertebereichs liegt.

**13.** Verfahren nach Anspruch 11 oder 12,
**dadurch gekennzeichnet,**
**dass** in der Zeitkonstanten-Mittelwertbildung zum Berechnen des effektiven tau-Wertes (54, tau_eff) fortlaufend aus jeweils drei verschachtelt zusammengefassten Zeitkonstanten ($tau_i$) ein verschachtelter tau-Mittelwert ($tau\_avg_k$) und ein tau-Differenzenquotient zweiter Ordnung ($tau''_k$) berechnet werden (52), wobei eine zweite Regelung (53) erfolgt, welche die Anzahl M in Abhängigkeit des tau-Differenzenquotienten zweiter Ordnung ($tau''_k$) derart einstellt, dass der tau-Differenzenquotient zweiter Ordnung ($tau''_k$) innerhalb eines zulässigen zweiten Wertebereichs liegt, und anschließend eine Mittelwertbildung über eine Anzahl K der verschachtelten tau-Mittelwerte ($tau\_avg_k$) zur Berechnung des effektiven tau-Wertes (tau_eff) erfolgt.

**14.** Verfahren nach einem der Ansprüche 8 bis 13,
**dadurch gekennzeichnet,**
**dass** aus einem der gespeicherten, zeitdiskreten Spannungs-Messwerte ($V_i$=V1, V2, V3), dem jeweils zugehörigem Zeitpunkt (t1, t2, t3) und dem effektiven tau-Wert (tau_eff) ein stationärer Endwert (Vstat) der Kondensatorspannung berechnet wird.

**Claims**

**1.** A method (40) for quickly measuring an insulation resistance for the application in a method (15) for determining the insulation resistance (R_F1, R_F2) according to a pulse measuring method in an ungrounded power supply system (2), a measuring voltage ($U_0$) compiled of temporally consecutive square measuring pulses being applied between an active conductor (HV+, HV-) of the ungrounded power supply system (2) and ground (4) by means of a measuring pulse generator (6) via a coupling branch having a coupling resistance (R_C1, R_C2) and a measuring resistance (R_M1, R_M2) and a continuous-time curve of a voltage ($U_m$) measured via the measuring resistance (R_M1, R_M2) being captured, the method comprising the following steps:

> forming and storing a sequence of time-discrete output-voltage measured values ($V_i$) from the curve of the measured voltage ($U_m$),
> calculating time constants (50, $tau_i$) as negative quotient from a derivative of the first order ($V'_i$) and a derivative of the second order ($V''_i$) of time-discrete output-voltage measured values ($V_i$ = V1, V2, V3) stored at temporally directly consecutive points in time (T1, T2, T3) in a calculating period ($T_c$) within a settling phase of the square measuring pulse,
> calculating an effective tau value (54, tau_eff) via time constant averaging,
> **characterized by**
> indicating (55) a target charging state (r) of the network capacities (C_F1, C_F2) available in the ungrounded power supply system,
> calculating a target point in time (Tt) at which the network capacities (C_F1, C_F2) will have reached the target charging state (r) from the target charging state (r) and the effective tau value (54, tau-eff),
> calculating a first wait time (dTr) starting from the current point in time (T3) as the difference between the target point in time (Tt) and the current point in time (T3),
> outputting a safe-to-start signal (ss) should the first wait time (dTr) be less than an indicated quick-start time (Ts), otherwise outputting a not-safe-to-start signal (ns).

2. The method according to claim 1,
   **characterized in that**

   > the time-discrete output-voltage measured values ($V_i$) are formed by generating a sequence of time-discrete input-voltage measured values ($U_i$) by sampling (42) the curve of the measured voltage ($U_m$) with a pre-specified sampling rate,
   > by calculating the time-discrete output-voltage measured values ($V_i$) from the time-discrete input-voltage measured values ($U_i$) via measured-value averaging (44, 48) via sampling-rate reduction, by calculating filtered voltage measured values ($Y_i$) via digital low-pass filtering (46) of decimated voltage measured values ($X_i$).

3. The method according to claim 2,
   **characterized in that**
   the measured-value averaging comprises a first averaging (44), the decimated voltage measured values ($X_i$) each being formed consecutively without overlap via a number N of the time-discrete input-voltage measured values ($U_i$).

4. The method according to claim 2 or 3,
   **characterized in that**
   the measured-value averaging comprises a second averaging (48), the time-discrete output-voltage measured values ($V_i$) each being formed consecutively without overlap via a number M of the filtered voltage measured values ($Y_i$) and the number M being adapted to the temporal behavior of the time-discrete output-voltage measured values ($V_i$).

5. The method according to claim 4,
   **characterized in that**
   the adaption takes place via a first control (49), which sets the number M as a function of the derivative of the second order ($V''_i$) of the time-discrete output-voltage measured values ($V_i$) in such a manner that the derivative of the second order ($V''_i$) of the time-discrete output-voltage measured values ($V_i$) is within an admissible first value range.

6. The method according to claim 4 or 5,
   **characterized in that**
   an interleaved tau average ($tau\_avg_k$) and a tau derivative of the second order ($tau''_k$) are each calculated in the time-constant averaging for calculating the effective tau value (54, tau_eff) continuously from three time constants ($tau_i$), which are summarized in an interleaved manner, a second control (53) taking place which sets the number M as a function of the tau derivative of the second order ($tau''_k$) in such a manner that the tau derivative of the second order ($tau''_k$) is within an admissible second value range, and subsequently an averaging takes place via a number K of the interleaved tau averages ($tau\_avg_k$) for calculating the effective tau value (tau_eff).

7. The method according to any one of the claims 1 to 6,

**characterized in that**

a stationary final value (Vstat) of the capacitor voltage is calculated from one of the stored, time-discrete voltage measured values ($V_i$ = V1, V2, V3), from the correspondingly assigned point in time (t1, t2, t3) and from the effective tau value (tau_eff).

**8.** A method (30) for quickly measuring insulation resistances for the application in a method (15) for determining the insulation resistance (R_F1, R_F2) according to a pulse measuring method in an ungrounded power supply system (2), a measuring voltage ($U_0$) compiled of temporally consecutive square measuring pulses being applied between an active conductor (HV+, HV-) of the ungrounded power supply system (2) and ground (4) by means of a measuring pulse generator (6) via a coupling branch having a coupling resistance (R_C1, R_C2) and a measuring resistance (R_M1, R_M2) and a continuous-time curve of a voltage ($U_m$) measured via the measuring resistance (R_M1, R_M2) being captured, the method comprising the following steps:

forming and storing a sequence of time-discrete output-voltage measured values ($V_i$) from the curve of the measured voltage ($U_m$),
calculating time constants (50, $tau_i$) as negative quotient from a derivative of the first order ($V'_i$) and a derivative of the second order ($V''_i$) of time-discrete output-voltage measured values ($V_i$ = V1, V2, V3) stored at temporally directly consecutive points in time (T1, T2, T3) in a calculating period ($T_c$) within a settling phase of the square measuring pulse,
calculating an effective tau value (54, tau_eff) via time constant averaging,
**characterized by**
indicating (35) a target charging rate (kt), which is to be achieved in a target point in time (Tt) at the network capacities (C_F1, C_F2) available in the ungrounded power supply system, calculating a second wait time (dTv) starting from the T2 point in time (T2) as the difference between the target point in time (Tt) and the T2 point in time (T2) from the effective tau value (54, tau_eff) and starting from the quotient from the target charging rate (kt) and the determined derivative of the first order (V'2) to the T2 point in time (T2),
outputting a safe-to-start signal (ss) should the second wait time be less than a pre-specified quick-start time (Ts), otherwise outputting a not-safe-to-start signal (ns).

**9.** The method according to claim 8,
**characterized in that**

the time-discrete output-voltage measured values ($V_i$) are formed by generating a sequence of time-discrete input-voltage measured values ($U_i$) by sampling (42) the curve of the measured voltage ($U_m$) with a pre-specified sampling rate,
by calculating the time-discrete output-voltage measured values ($V_i$) from the time-discrete input-voltage measured values ($U_i$) via measured-value averaging (44, 48) via sampling-rate limitation,
by calculating filtered voltage measured values ($Y_i$) via digital low-pass filtering (46) of decimated voltage measured values ($X_i$).

**10.** The method according to claim 2,
**characterized in that**
the measured-value averaging comprises a first averaging (44), the decimated voltage measured values ($X_i$) each being formed consecutively without overlap via a number N of the time-discrete input-voltage measured values ($U_i$).

**11.** The method according to claim 9 or 10,
**characterized in that**
the measured-value averaging comprises a second averaging (48), the time-discrete output-voltage measured values ($V_i$) each being formed consecutively without overlap via a number M of the filtered voltage measured values ($Y_i$) and the number M being adapted to the temporal behavior of the time-discrete output-voltage measured values ($V_i$).

**12.** The method according to claim 11,
**characterized in that**
the adaption takes place via a first control (49), which sets the number M as a function of the derivative of the second order ($V''_i$) of the time-discrete output-voltage measured values ($V_i$) in such a manner that the derivative of the second order ($V''_i$) of the time-discrete output-voltage measured value ($V_i$) is within an admissible first value range.

**13.** The method according to claim 11 or 12,
**characterized in that**
an interleaved tau average (tau_avg$_k$) and a tau derivative of the second order (tau"$_k$) are calculated in the time-constant averaging for calculating the effective tau value (54, tau_eff) continuously from three time constants (tau$_i$) each, which are summarized in an interleaved manner, a second control (53) taking place which sets the number M as a function of the tau derivative of the second order (tau"$_k$) in such a manner that the tau derivative of the second order (tau"$_k$) is within an admissible second value range, and subsequently an averaging takes place via a number K of the interleaved tau averages (tau_avg$_k$) for calculating the effective tau value (tau_eff).

**14.** The method according to any one of the claims 8 to 13,
**characterized in that**
a stationary final value (Vstat) of the capacitor voltage is calculated from one of the stored, time-discrete voltage measured values (V$_i$ = V1, V2, V3), from the correspondingly assigned point in time (t1, t2, t3) and the effective tau value (tau_eff).

**Revendications**

**1.** Procédé (40) de mesure rapide d'une résistance d'isolement pour l'application dans un procédé (15) de détermination de la résistance d'isolement (R_F1, R_F2) selon un procédé de mesure d'impulsions dans un système (2) d'alimentation en énergie non mis à la terre, une tension de mesure (U$_0$) composée d'impulsions de mesure carrées temporellement consécutives étant appliquée entre un conducteur actif (HV+, HV-) du système (2) d'alimentation en énergie non mis à la terre et la terre (4) au moyen d'un générateur (6) d'impulsions de mesure par l'intermédiaire d'une branche de couplage ayant une résistance de couplage (R_C1, R_C2) et une résistance de mesure (R_M1, R_M2) et une courbe en temps continu d'une tension (Um) mesurée par l'intermédiaire de la résistance de mesure (R_M1, R_M2) étant capturée, le procédé comprenant les étapes suivantes :

former et stocker une séquence de valeurs de mesure (Vi) de la tension de sortie discrètes dans le temps à partir de la courbe de la tension de mesure (U$_m$),
calculer des constantes de temps (50, tau$_i$) comme quotient négatif d'un quotient de différence (V'$_i$) du premier ordre et d'un quotient de différence (V"$_i$) du deuxième ordre à partir de valeurs de mesure (V$_i$ = V1, V2, V3) de la tension de sortie discrètes dans le temps et stockées à des instants (T1, T2, T3) temporellement directement consécutifs dans une période de calcul (T$_c$) dans une phase de rétablissement de l'impulsion de mesure carrée,
calculer une valeur tau effective (54, tau_eff) par calcul de la moyenne de la constante de temps,
**caractérisé par**
indiquer (55) un état de charge cible (r) des capacités de réseau (C_F1, C_F2) disponibles dans le système d'alimentation en énergie non mis à la terre,
calculer un instant cible (Tt) auquel les capacités de réseau (C_F1, C_F2) auront atteint l'état de charge cible (r) à partir de l'état de charge cible (r) et de la valeur tau effective (54, tau-eff),
calculer un premier temps d'attente (dTr) à partir de l'instant actuel (T3) comme la différence entre l'instant cible (Tt) et l'instant actuel (T3),
émettre un signal de démarrage sûr (ss) si le premier temps d'attente (dTr) est inférieur à un temps de démarrage rapide (Ts) indiqué, sinon émettre un signal de démarrage non sûr (ns).

**2.** Procédé selon la revendication 1,
**caractérisé en ce que**

les valeurs de mesure (Vi) de la tension de sortie discrètes dans le temps sont formées
en générant une séquence de valeurs de mesure (Ui) de la tension d'entrée discrètes dans le temps en échantillonnant (42) la courbe de la tension mesurée (Um) avec un taux d'échantillonnage prédéfini,
en calculant les valeurs de mesure (Vi) de la tension de sortie discrètes dans le temps à partir des valeurs de mesure (Ui) de la tension d'entrée discrètes dans le temps par l'intermédiaire d'un calcul de moyenne (44, 48) des valeurs de mesure par l'intermédiaire d'une réduction du taux d'échantillonnage,
en calculant les valeurs (Yi) de mesure filtrées de tension par l'intermédiaire d'un filtrage passe-bas numérique (46) des valeurs (X$_i$) de mesure de tension décimées.

**3.** Procédé selon la revendication 2,
**caractérisé en ce que**

le calcul de moyenne des valeurs mesurées comprend un premier calcul de moyenne (44), les valeurs de mesure ($X_i$) décimées de la tension étant formées chacune consécutivement sans chevauchement par l'intermédiaire d'un nombre N des valeurs de mesure ($U_i$) de la tension d'entrée discrètes dans le temps.

4. Procédé selon la revendication 2 ou la revendication 3,
**caractérisé en ce que**
le calcul de moyenne des valeurs de mesure comprend un deuxième calcul de moyenne (48) des valeurs de mesure , les valeurs de mesure ($V_i$) de la tension de sortie discrètes dans le temps étant formées chacune consécutivement sans chevauchement par l'intermédiaire d'un nombre M des valeurs de mesure ($Y_i$) de la tension filtrées et le nombre M étant adapté au comportement temporel des valeurs de mesure ($V_i$) de la tension de sortie discrètes dans le temps.

5. Procédé selon la revendication 4,
**caractérisé en ce que**
l'adaptation s'effectue par l'intermédiaire d'une première commande (49), qui règle le nombre M en fonction du quotient de différence ($V''_i$) du deuxième ordre des valeurs de mesure ($V_i$) de la tension de sortie discrètes dans le temps de telle manière que le quotient de différence ($V''_i$) du deuxième ordre des valeurs de mesure ($V_i$) de la tension de sortie discrètes dans le temps se situe dans une première plage de valeurs admissible.

6. Procédé selon la revendication 4 ou la revendication 5,
**caractérisé en ce**
**qu'**une moyenne tau entrelacée ($tau\_avg_k$) et un quotient de différence tau ($tau''_k$) du deuxième ordre sont calculés chacun dans le calcul de moyenne à constante de temps pour calculer consécutivement la valeur tau effective (54, tau\_eff) à partir de trois constantes de temps ($tau_i$), qui sont résumées de manière entrelacée, une deuxième commande (53) ayant lieu qui règle le nombre M en fonction du quotient de différence tau ($tau''_k$) du deuxième ordre de telle manière que le quotient de différence tau ($tau''_k$) du deuxième ordre se situe dans une deuxième plage de valeurs admissible, et par la suite un calcul de moyenne a lieu par l'intermédiaire d'un nombre K des moyennes tau entrelacées ($tau\_avg_k$) pour calculer la valeur tau effective (tau\_eff).

7. Procédé selon l'une quelconque des revendications 1 à 6,
**caractérisé en ce**
**qu'**une valeur finale (Vstat) stationnaire de la tension du condensateur est calculée à partir de l'une des valeurs de mesure de la tension stockées et discrètes dans le temps ($V_i$ = V1, V2, V3), à partir du moment correspondant (t1, t2, t3) et à partir de la valeur tau effective (tau\_eff).

8. Procédé (30) de mesure rapide d'une résistance d'isolement pour l'application dans un procédé (15) de détermination de la résistance d'isolement (R_F1, R_F2) selon un procédé de mesure d'impulsions dans un système (2) d'alimentation en énergie non mis à la terre, une tension de mesure ($U_0$) composée d'impulsions de mesure carrées temporellement consécutives étant appliquée entre un conducteur actif (HV+, HV-) du système (2) d'alimentation en énergie non mis à la terre et la terre (4) au moyen d'un générateur (6) d'impulsions de mesure par l'intermédiaire d'une branche de couplage ayant une résistance de couplage (R_C1, R_C2) et une résistance de mesure (R_M1, R_M2) et une courbe en temps continu d'une tension (Um) mesurée par l'intermédiaire de la résistance de mesure (R_M1, R_M2) étant capturée, le procédé comprenant les étapes suivantes :

former et stocker une séquence de valeurs de mesure (Vi) de la tension de sortie discrètes dans le temps à partir de la courbe de la tension de mesure ($U_m$),
calculer des constantes de temps (50, $tau_i$) comme quotient négatif d'un quotient de différence ($V'_i$) du premier ordre et d'un quotient de différence ($V''_i$) du deuxième ordre à partir de valeurs de mesure ($V_i$ = V1, V2, V3) de la tension de sortie discrètes dans le temps et stockées à des instants (T1, T2, T3) temporellement directement consécutifs dans une période de calcul ($T_c$) dans une phase de rétablissement de l'impulsion de mesure carrée,
calculer une valeur tau effective (54, tau\_eff) par calcul de la moyenne de la constante de temps,
**caractérisé par**
indiquer (35) un taux de charge cible (kt), qui doit être atteint à un moment cible (Tt) aux capacités de réseau (C_F1, C_F2) disponibles dans le système d'alimentation en énergie non mis à la terre,
calculer un deuxième temps d'attente (dTv) à partir du point temporel T2 (T2) comme la différence entre le point temporel cible (Tt) et le point temporel T2 (T2) à partir de la valeur tau effective (54, tau\_eff) et à partir du quotient du taux de charge cible (kt) et du quotient de différence ($V'2$) du premier ordre déterminée jusqu'au point temporel T2 (T2),
émettre un signal de démarrage sûr (ss) si le deuxième temps d'attente (dTr) est inférieur à un temps de démarrage rapide (Ts) indiqué, sinon émettre un signal de démarrage non sûr (ns).

9.  Procédé selon la revendication 8,
    **caractérisé en ce que**

    les valeurs de mesure (Vi) de la tension de sortie discrètes dans le temps sont formées
    en générant une séquence de valeurs de mesure (Ui) de la tension d'entrée discrètes dans le temps en échantillonnant (42) la courbe de la tension mesurée (Um) avec un taux d'échantillonnage prédéfini,
    en calculant les valeurs de mesure (Vi) de la tension de sortie discrètes dans le temps à partir des valeurs de mesure (Ui) de la tension d'entrée discrètes dans le temps par l'intermédiaire d'un calcul de moyenne (44, 48) des valeurs de mesure par l'intermédiaire d'une réduction du taux d'échantillonnage,
    en calculant les valeurs (Yi) de mesure filtrées de tension par l'intermédiaire d'un filtrage passe-bas numérique (46) des valeurs ($X_i$) de mesure de tension décimées.

10. Procédé selon la revendication 2,
    **caractérisé en ce que**
    le calcul de moyenne des valeurs mesurées comprend un premier calcul de moyenne (44), les valeurs de mesure ($X_i$) décimées de la tension étant formées chacune consécutivement sans chevauchement par l'intermédiaire d'un nombre N des valeurs de mesure ($U_i$) de la tension d'entrée discrètes dans le temps.

11. Procédé selon la revendication 9 ou la revendication 10,
    **caractérisé en ce que**
    le calcul de moyenne des valeurs de mesure comprend un deuxième calcul de moyenne (48) des valeurs de mesure , les valeurs de mesure ($V_i$) de la tension de sortie discrètes dans le temps étant formées chacune consécutivement sans chevauchement par l'intermédiaire d'un nombre M des valeurs de mesure ($Y_i$) de la tension filtrées et le nombre M étant adapté au comportement temporel des valeurs de mesure ($V_i$) de la tension de sortie discrètes dans le temps.

12. Procédé selon la revendication 11,
    **caractérisé en ce que**
    l'adaptation s'effectue par l'intermédiaire d'une première commande (49), qui règle le nombre M en fonction du quotient de différence ($V''_i$) du deuxième ordre des valeurs de mesure ($V_i$) de la tension de sortie discrètes dans le temps de telle manière que le quotient de différence ($V''_i$) du deuxième ordre des valeurs de mesure ($V_i$) de la tension de sortie discrètes dans le temps se situe dans une première plage de valeurs admissible.

13. Procédé selon la revendication 11 ou la revendication 12,
    **caractérisé en ce**
    **qu'**une moyenne tau entrelacée ($tau\_avg_k$) et un quotient de différence tau ($tau''_k$) du deuxième ordre sont calculés chacun dans le calcul de moyenne à constante de temps pour calculer consécutivement la valeur tau effective (54, tau_eff) à partir de trois constantes de temps ($tau_i$), qui sont résumées de manière entrelacée, une deuxième commande (53) ayant lieu qui règle le nombre M en fonction du quotient de différence tau ($tau''_k$) du deuxième ordre de telle manière que le quotient de différence tau ($tau''_k$) du deuxième ordre se situe dans une deuxième plage de valeurs admissible, et par la suite un calcul de moyenne a lieu par l'intermédiaire d'un nombre K des moyennes tau entrelacées ($tau\_avg_k$) pour calculer la valeur tau effective (tau_eff).

14. Procédé selon l'une quelconque des revendications 8 à 13,
    **caractérisé en ce**
    **qu'**une valeur finale (Vstat) stationnaire de la tension du condensateur est calculée à partir de l'une des valeurs de mesure de la tension stockées et discrètes dans le temps ($V_i$ = V1, V2, V3), à partir du moment correspondant (t1, t2, t3) et à partir de la valeur tau effective (tau_eff).

**Fig. 1**

Stand der Technik

EP 4 361 649 B1

**Fig. 2a**

**Fig. 2b**

EP 4 361 649 B1

Fig. 3a

Fig. 3b

**Fig. 4**

Fig. 5

**Fig. 6**

**Fig. 7**

**Fig. 8**

Vi          tau"k

tau_eff

**Fig. 9**

| 0 | 1 | 2 | 3 | 4 | 5 | 6 | 7 | 8 | 9 | 10 | 11 |
|---|---|---|---|---|---|---|---|---|---|----|----|

K=4 {  
0    4    8  
1    5    9  
2    6    10  
3    7    11

**Fig. 10**

Fig. 11

Fig. 12

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102021101693 B3